(19) Europäisches Patentamt
European Patent Office
Office européen des brevets

(11) EP 4 769 944 A2

(12) EUROPEAN PATENT APPLICATION

(43) Date of publication:
01.07.2026 Bulletin 2026/27

(21) Application number: 25211588.6

(22) Date of filing: 28.10.2025

(51) International Patent Classification (IPC):
H03K 3/03 (2006.01)     H03K 19/003 (2006.01)

(52) Cooperative Patent Classification (CPC):
H03K 3/0315; H03K 19/00323

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 26.12.2024 US 202419002436

(71) Applicant: INTEL Corporation
Santa Clara, CA 95054 (US)

(72) Inventors:
• BRANTNER, Zachary
Portland, 97223 (US)
• LIN, Maojing
Beaverton, 97006 (US)
• SOMASEKHAR, Dinesh
Portland, 97229 (US)
• SRINIVASAN, Gopal
Saratoga, 95070 (US)

(74) Representative: HGF
HGF Limited
4th Floor, 1 City Square
Leeds LS1 2ES (GB)

(54) RING OSCILLATOR

(57) An apparatus comprises a first OR gate, a second OR gate, a first NAND gate, and a second NAND gate. The first OR gate comprises a first input terminal, a second input terminal, and an output terminal. The second OR gate comprises a first input terminal, a second input terminal, and an output terminal. The first NAND gate comprises a first input terminal coupled to the output terminal of the first OR gate. The first NAND gate also comprises a second input terminal coupled to the output terminal of the second OR gate. The second NAND gate comprises an output terminal coupled to the first input terminal of the second OR gate.

FIG. 1

EP 4 769 944 A2

## Description

BACKGROUND

Conventional ring oscillators (ROs) use a fixed-length design associated with a fixed number of oscillating stages, which allows for a single measurement on a single physical oscillator.

BRIEF DESCRIPTION OF THE DRAWINGS

In the drawings, like numerals may describe the same or similar components or features in different views. Like numerals having different letter suffixes may represent different instances of similar components. Some embodiments are illustrated by way of example, and not limitation, in the figures of the accompanying drawings listed below.

FIG. 1 is an RO architecture using sub-oscillator segments, in accordance with some embodiments.

FIG. 2 is a block diagram of a RO using And-Or-Invert (AOI) gates, in accordance with some embodiments.

FIG. 3 is a block diagram of a RO using Or-And-Invert (OAI) gates, in accordance with some embodiments.

FIG. 4 is a block diagram of a sub-oscillator segment configured as an RO layout building block, in accordance with some embodiments.

FIG. 5 is a block diagram of example RO designs with different oscillation configurations, in accordance with some embodiments.

FIG. 6 is a graph of the frequency of a single physical RO reconfigured to different effective lengths across voltages, in accordance with some embodiments.

FIG. 7 is a diagram of RO variations for resistance-capacitance (RC) de-embedding, in accordance with some embodiments.

FIG. 8 is a graph of the frequency ratio of one driver driving two receivers versus one driver driving one receiver, at three different wire lengths, in accordance with some embodiments.

FIG. 9 is a flow diagram of an example process of making a ring oscillator, in accordance with some embodiments.

FIG. 10 illustrates a block diagram of an example machine upon which any one or more of the operations/techniques (e.g., methodologies) discussed herein may perform.

DETAILED DESCRIPTION

The following detailed description refers to the accompanying drawings. The same reference numbers may be used in different drawings to identify the same or similar elements. In the following description, for purposes of explanation and not limitation, specific details are set forth, such as particular structures, architectures, interfaces, techniques, etc., to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail.

The following description and the drawings sufficiently illustrate specific embodiments to enable those skilled in the art to practice them. Other embodiments may incorporate structural, logical, electrical, process, and other changes. Portions and features of some embodiments may be included in or substituted for those of other embodiments. Embodiments outlined in the claims encompass all available equivalents of those claims.

As used herein, the term "chip" (or die) refers to a piece of a material, such as a semiconductor material, that includes a circuit, such as an integrated circuit or a part of an integrated circuit. The term "memory IP" indicates memory intellectual property. The terms "memory IP," "memory device," "memory chip," and "memory" are interchangeable.

The term "a processor" configured to carry out specific operations includes both a single processor configured to carry out all of the operations (e.g., operations or methods disclosed herein) as well as multiple processors individually configured to carry out some or all of the operations (which may overlap) such that the combination of processors carry out all of the operations.

As used herein, the term "IO" indicates input/output. As used herein, the term "R-C" indicates resistance and capacitance. As used herein, the term "Rx" indicates receiver (or receive). As used herein, the term "Tx" indicates transmitter (or transmit). As used herein, the term "TRX" indicates transceiver. As used herein, the term "UCIe" indicates Universal Chiplet Interconnect Express. As used herein, the term "Vref" indicates reference voltage. As used herein, the term "Vin" indicates input voltage. As used herein, the terms "serially coupled," "serially connected," and "connected in series" are synonymous to each other and indicate a serial connection between two or more components/circuits where the serial connection can be based on a direct or indirect electrical connection between the two or more components/-circuits. As used herein, the terms "parallel coupled," "parallel connected," and "connected in parallel" are synonymous to each other and indicate a parallel connection between two or more components/circuits where the parallel connection can be based on a direct or indirect electrical connection between the two or more components/circuits.

The disclosed techniques include an RO that can modulate the number of oscillating stages (also referred to as RO stages) and the location of oscillation in situ. In some aspects, two or more RO stages can be implemented as a sub-oscillator segment. In some aspects, an RO stage uses identical circuits. It can be designed to ensure odd RO lengths are formed, eliminating the need for any explicit inversion logic required for any configuration. In some aspects, an RO stage of the disclosed RO architecture can select its input signal as either the output of the preceding stage (e.g., a normal operating mode) or as the output of the stage across from it on the ring (e.g., a bypass operating mode). Since RO stages can be identical and RO stages can be added or subtracted in the same RO, variation of stage delay can be de-embedded using just frequency measurements. In some aspects, using variations of the disclosed architecture designs (e.g., variation of the distance between stages), the effects of metal wire and cell RC can also be de-embedded.

An advantage of the disclosed RO architectures compared to fixed-length ROs is that multiple measurements can be performed on a single physical oscillator, which allows for discrimination of the effects of random variation in devices. In some aspects, sequential RO stages can be added, removed, or shifted at will with control signals, ensuring that the resulting change in RO frequency solely comes from those stages that changed, not from additional random device variation of a different physical design, as with fixed-length ROs. Additionally, by using cell and layout variations based on the disclosed RO architectures, such as varying interconnect distance between cells, devices, and metal RC, it can be calibrated with a higher precision.

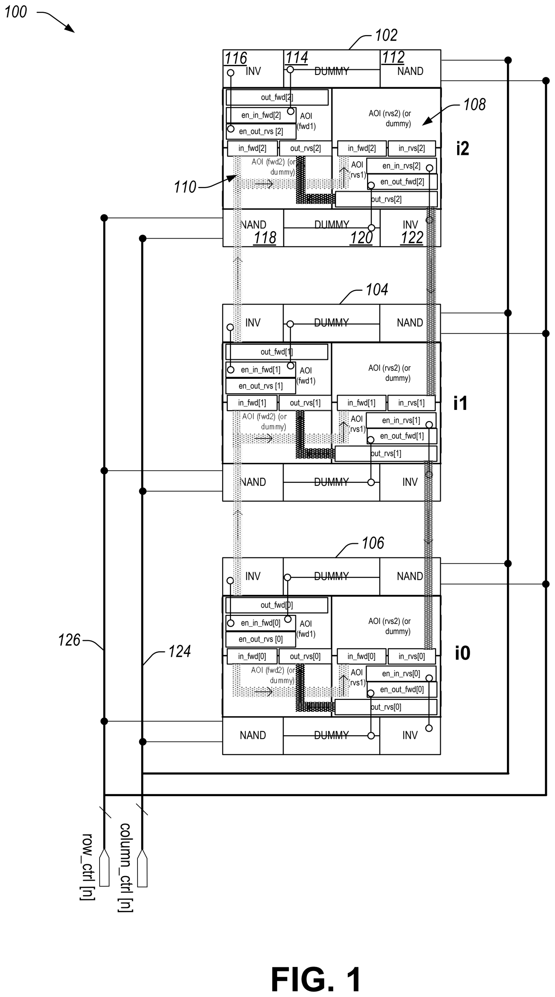

FIG. 1 is an RO architecture 100 using sub-oscillator segments, in accordance with some embodiments. Referring to FIG. 1, RO architecture 100 includes multiple RO circuits that can be identical, such as sub-oscillator segments (SOSs) 102, 104, and 106. A more detailed reference number designation is provided for SOS 102, but the remaining SOSs can be configured similarly.

In some aspects, SOS 102 includes two RO stages, including corresponding And-Or-Invert (AOI) gates 108 and 110. The RO stage associated with AOI gate 108 also includes a NAND gate 112, a dummy circuit 114, and an inverter 116. Similarly, the RO stage associated with AOI gate 110 also includes a NAND gate 118, a dummy circuit 120, and an inverter 122.

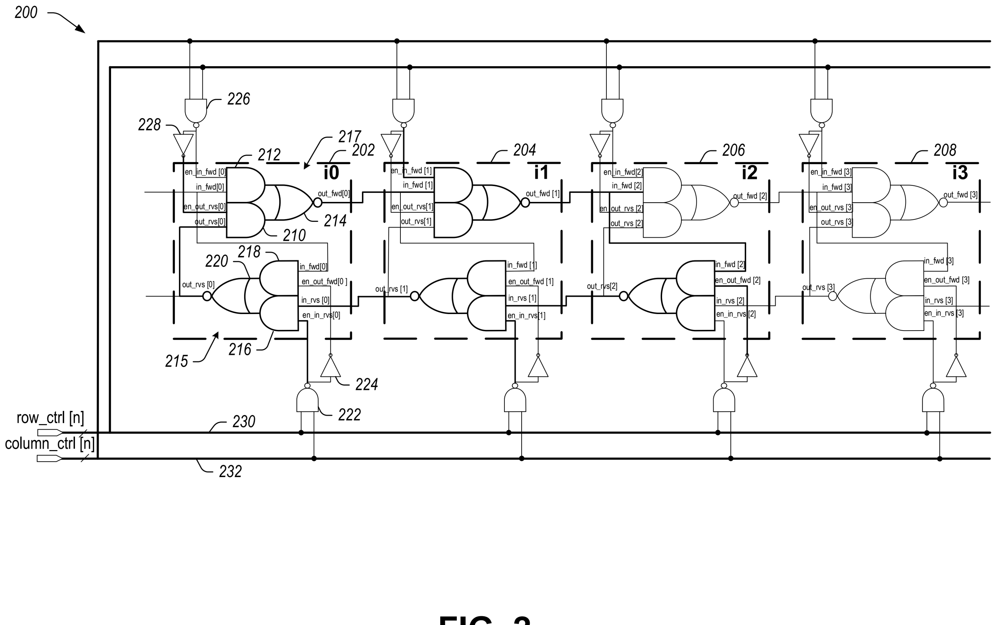

Example ROs using RO stages with AOI gates or Or-And-Invert (OAI) gates are discussed in connection with FIGS. 2-9.

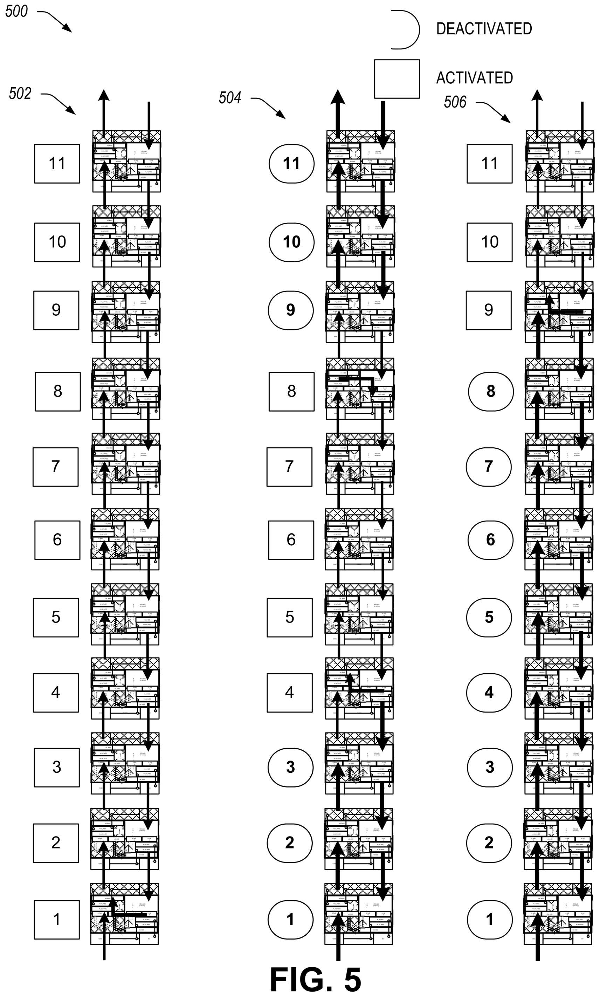

In some aspects, an RO can be configured as a strip of identical stages comprised of a uniformly repeating pattern of SOSs (e.g., as illustrated in FIG. 5). This repeating pattern of SOSs can be uniformly separated with metal connections for forward and reverse paths to connect neighboring RO stages. In addition to the forward and reverse metal connections, each SOS has uniformly connected control inputs (e.g., reset signals from reset rails 124 and 126), which can be used to configure whether the RO stage input comes from the previous RO stage or the bypass stage. FIG. 1 shows an example of this where the control (or reset) signals from reset rails 124 and 126 are uniformly connected on the side of the SOSs.

FIG. 2 is a block diagram of a RO using AOI gates, in accordance with some embodiments. Referring to FIG. 2, RO 200 comprises SOSs 202, 204, 206, and 208, which can be associated with the same circuit configuration. An example configuration of SOS 202 is referenced in FIG. 2, but the remaining SOSs can have a similar configuration.

SOS 202 includes RO stage 215 comprising AND gates 216 and 218 and NOR gate 220. RO stage 215 can also comprise inverter 224 and NAND gate 222, which can be used to provide RO stage 215 with control/reset signals based on signals from reset rails 230 and 232.

SOS 202 also includes RO stage 217 comprising AND gates 210 and 212 and NOR gate 214. RO stage 217 can also comprise inverter 228 and NAND gate 226, which can be used to provide RO stage 217 with control/reset signals based on signals from reset rails 230 and 232.

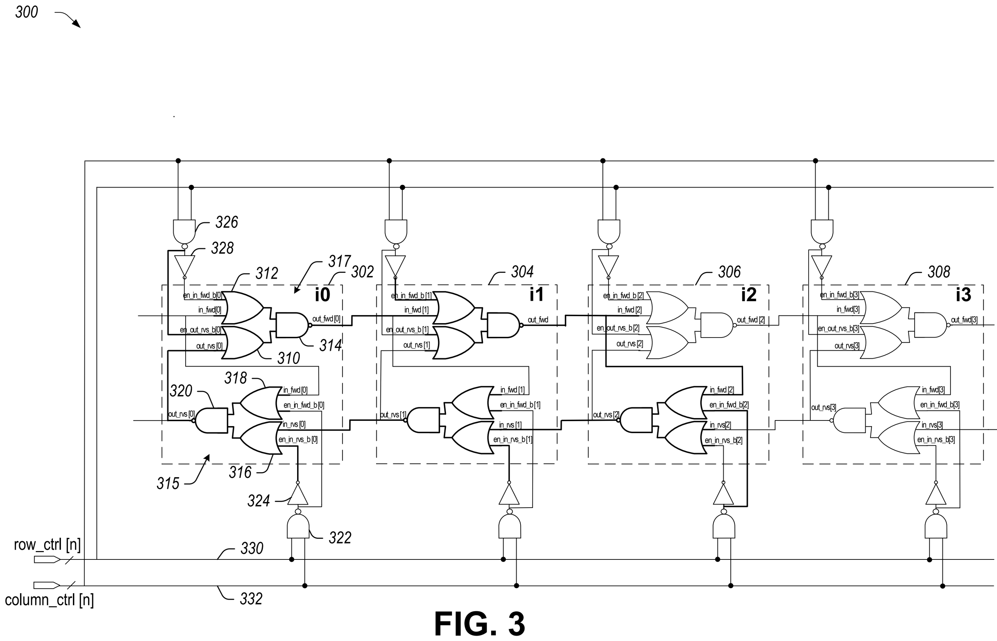

FIG. 3 is a block diagram of a RO using OAI gates, in accordance with some embodiments. Referring to FIG. 3, RO 300 comprises SOSs 302, 304, 306, and 308, which can be associated with the same circuit configuration. An example configuration of SOS 302 is referenced in FIG. 3, but the remaining SOSs can have a similar configuration.

SOS 302 includes RO stage 315 comprising OR gates 316 and 318 and NAND gate 320. RO stage 315 can also comprise inverter 324 and NAND gate 322, which can be used to provide RO stage 315 with control/reset signals based on signals from reset rails 330 and 332.

SOS 302 also includes RO stage 317, which comprises OR gates 310 and 312 and NAND gate 314. RO stage 317 can also comprise inverter 328 and NAND gate 326, which can be used to provide RO stage 317 with control/reset signals based on signals from reset rails 330 and 332.

In some aspects, the disclosed control/reset signals based on the signals from the reset rails can be used as at least one input selection signal for configuring normal or bypass operation mode and, thereby, configuring the number of active RO stages of the RO architecture.

To allow reconfiguration of the number of active RO stages in an RO in-situ, the disclosed "bypass" system uses a 4-input AOI (or OAI) device for each RO stage (e.g., each of RO stages 215 and 217 uses two AND gates with 4 inputs per stage, and each of RO stages 315 and 317 uses two OR gates with 4 inputs per stage). This 4-input device at each stage, in addition to functioning as an inverter like in a traditional RO, effectively acts as a multiplexer (or mux) that selects between two input signals. One input is connected to the output of the preceding RO stage (for a normal operating mode). In contrast, another input is connected to the RO stage across from it in the oscillation ring (for a bypass operating mode). When configuring the RO using bypass operating mode(s), any RO stages outside of the bypass loop will become an inactive part of the oscillator (e.g., as illustrated in FIG. 5). In some aspects, there are two control signals (in addition to their negated signal) that feed into each AOI gate from the reset rails, which determines where the stage input is supplied from (e.g., whether a normal or a bypass input is used).

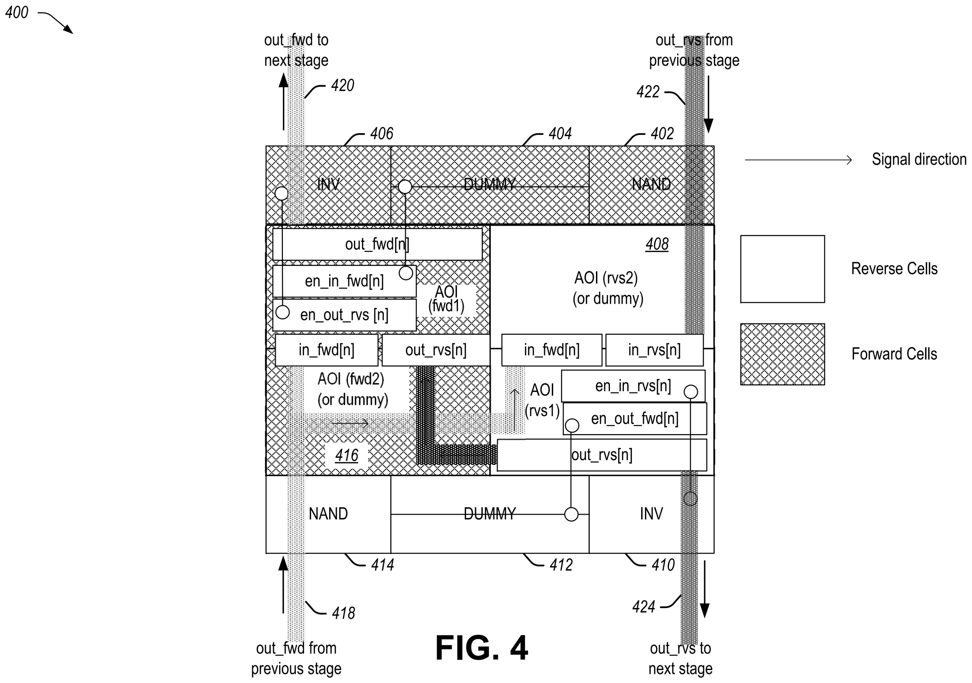

FIG. 4 is a block diagram of a sub-oscillator segment configured as an RO layout building block, in accordance with some embodiments. Referring to FIG. 4, SOS 400 includes two RO stages, including corresponding AOI gates 408 and 416. The RO stage associated with AOI gate 408 also includes a NAND gate 402, a dummy circuit 404, and an inverter 406. Similarly, the RO stage associated with AOI gate 416 also includes a NAND gate 414, a dummy circuit 412, and an inverter 410. Additionally, SOS 400 can include metal traces 418, 420, 422, and 424 for communication with neighboring SOSs in an RO architecture.

FIG. 4 illustrates a single building block (e.g., an SOS) of the disclosed RO design, with SOS 400 being illustrated as it would appear in a physical layout. In some aspects, the AOI gates are each a 4-input AOI, responsible for performing an inversion in the forward or the backward direction, respectively.

In some aspects, an extra AOI cell can be configured inside the SOS for each direction (as illustrated in FIG. 4), which is intended for differential loading for RC de-embedding. The inverter (also referenced as INV) and the NAND gate (also referenced as NAND) are examples of implementations of the control logic for the bypass system, and they drive the enable pins on the AOI (connections not drawn). For example, when a forward bypass is enabled, the forward stage takes its input from the output of the backward stage in the same circuit block. When a backward bypass is enabled, the backward stage takes its input from the output of the previous forward stage. This bypass design ensures that the final RO created has an odd number of stages.

In some aspects, circuits for multiple RO stages are identical, including the first and last stages (e.g., as illustrated in FIGS. 1-3). In this regard, no explicit inversion is needed for any of the possible RO length configurations. Identical stages also ensure identical local-layout effects (LLE), which enables high-precision RO measurements, including de-embedding RC using frequency and current.

FIG. 5 is a block diagram 500 of example RO designs with different oscillation configurations, in accordance with some embodiments. Referring to FIG. 5, RO configurations 502, 504, and 506 can be based on an RO design using 11 SOSs, where selective SOSs can be activated for an RO. For example, RO configuration 502 is based on an RO architecture using all 11 SOSs. RO configuration 504 is based on an RO architecture using SOSs 4-8. RO configuration 506 is based on an RO architecture using SOSs 9-11.

In some aspects, an RO design with 128 physical stages can be configured. For example, approximately 120 (128-7) unique 7-stage ROs can be configured, 18 groups of which can be independent. In some aspects, each RO gives a frequency measurement F, which is a random variable with a median frequency that is the median of all the oscillators. The spread of frequency F will result from random device variation, as all stages are identical. Given the number of samples, the distribution of F gives an insight into stage delay variation (delay stage = average (rise delay, fall delay) and std. deviation $SD(stage) = SD(F) \times sqrt(7)$). Test time may not be higher or lower than other methods for the same measurements, but with a higher test time, higher accuracy (sigma) than other methods can be achieved.

Additionally, since the RO size can be varied and configured in odd numbers (e.g., ranging from 3 to 127 stages), a large number of samples can be created. In some aspects, the maximum number of independent samples cannot exceed the stages in the design, which can be 127.

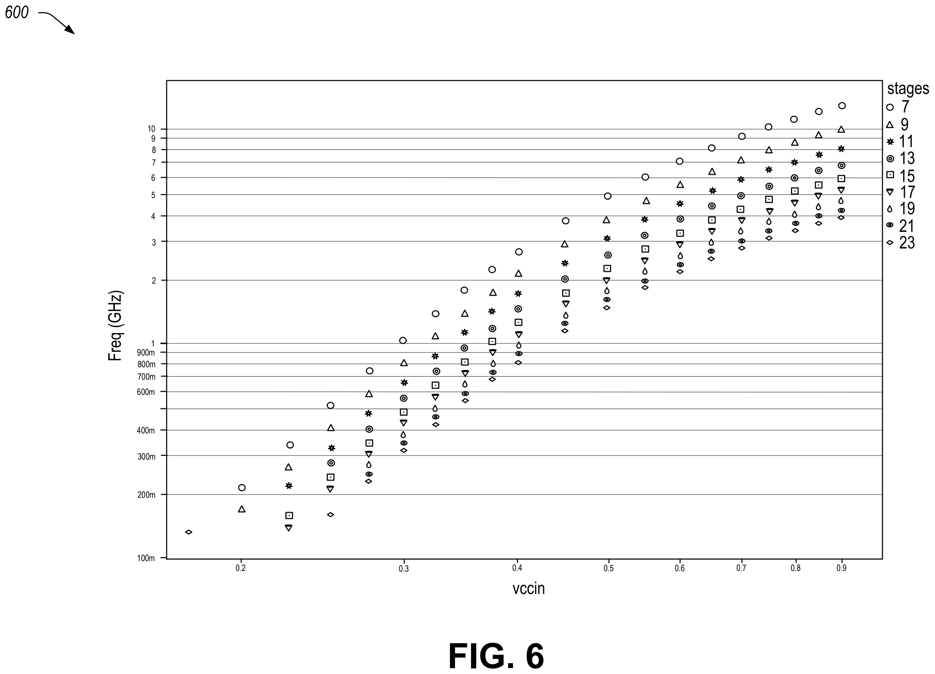

FIG. 6 is a graph 600 of the frequency of a single physical RO reconfigured to different effective lengths across voltages, in accordance with some embodiments. The simulation associated with FIG. 6 shows the frequency range of the same RO configured with different numbers of stages at various voltage levels. As can be deduced from graph 600, each increase in stage count decreases the effective RO frequency.

For example, an 11-stage oscillator is configured at 3 GHz. Assuming the random variation is canceled out, given that there are 11 stages, then a 13-stage oscillator would measure 11/13 x 3G = 2.54 GHz. If instead the oscillator measures as 2.58 GHz, then the residual (1/2.54 GHz) - (1/2.58 GHz) = 6.2 ps is from stage variation in the extra two stages (with average stage delay being 1/3 GHz / (2 x 11-stage) = 15ps) so that two stages have ~30 ps of delay. The SD/Mean of 6.2 ps / 15 ps is approximately 41%.

In addition to reconfigurability, the disclosed RO designs enable the measurement of resistance-capacitance (RC) components of the circuit with high precision.

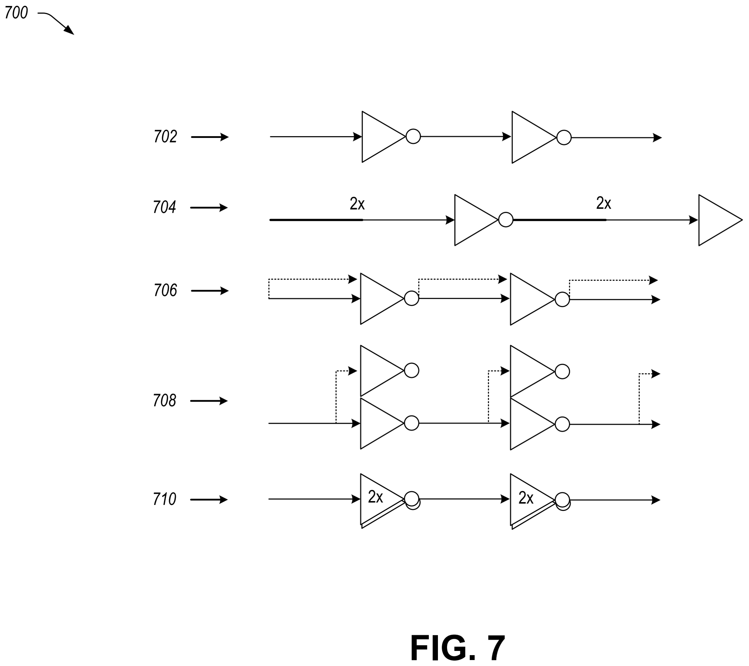

FIG. 7 is a diagram 700 of RO variations for resistance-capacitance (RC) de-embedding, in accordance with some embodiments. Referring to FIG. 7, five different RC values can be measured, which can be estimated using Elmore delay estimation based on inverter configurations 702, 704, 706, 708, and 710.

The 5 different RC values that can be measured are as follows: driver output resistance (RD), driver output capacitance (CD), receiver/gate capacitance (CR), metal wire capacitance (Cw/um), and metal wire resistance (Rw/um). To de-embed the 5 RC components, five different RO variations can be created (as illustrated by inverter configurations 702 - 710), each modeled with a unique Elmore delay equation with time delay (T).

The following Elmore delay equations in Table 1 can be used to estimate T for inverter configurations 702-710:

TABLE 1

For inverter configuration 702:

$$T_1 = R_D * \left( C_D + \frac{C_w}{2} * L \right) + (R_D + R_W * L) * \left( \frac{C_w}{2} * L + C_R \right)$$

For inverter configuration 704:

$$T_2 = R_D * \left( C_D + \frac{C_w}{2} * 2L \right) + (R_D + R_W * 2L) * \left( \frac{C_w}{2} * 2L + C_R \right)$$

For inverter configuration 706:

$$T_3 = R_D * \left( C_D + \frac{3C_w}{2} * L \right) + (R_D + R_W * L) * \left( \frac{3C_w}{2} * L + C_R \right)$$

For inverter configuration 708:

$$T_4 = R_D * \left( C_D + \frac{C_w}{2} * L \right) + (R_D + R_W * L) * \left( \frac{C_w}{2} * L + 2C_R \right)$$

For inverter configuration 710:

$$T_5 = \frac{R_{D1}}{2} * \left( 2C_D + \frac{C_w}{2} * L \right) + \left( \frac{R_{D1}}{2} + R_W * L \right) * \left( \frac{C_w}{2} * L + 2C_R \right)$$

In some aspects, metal wires connecting different RO stages are modeled with the Pi-model and have wire length L.

Referencing the baseline/normal oscillator, each RO variation changes an RC single component, such as increasing wire length (L) between RO stages or doubling the number of inputs an RO is driving. By comparing the change in measured frequency between each RO variation, the value of each RC component can be de-embedded. Since the disclosed RO design also allows reusing RO sections for different measurements, this feature can be used to distinguish random variation in RC as well. This unique feature is not present in existing RC-measurements ROs, which allows the disclosed techniques to be used for high-precision measurements.

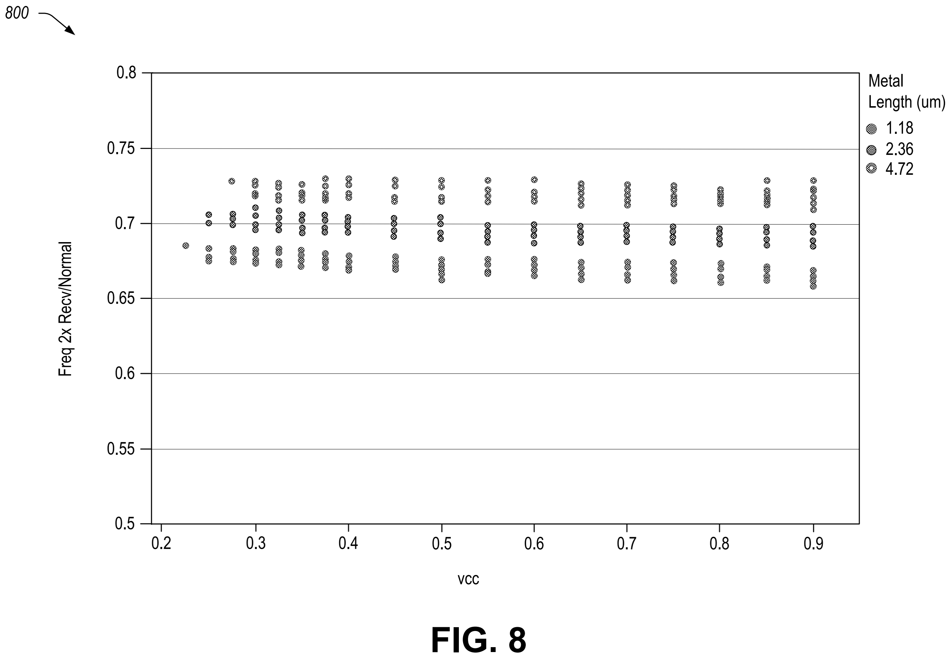

FIG. 8 is graph 800 of the frequency ratio of one driver driving two receivers versus one driver driving one receiver at three different wire lengths, in accordance with some embodiments.

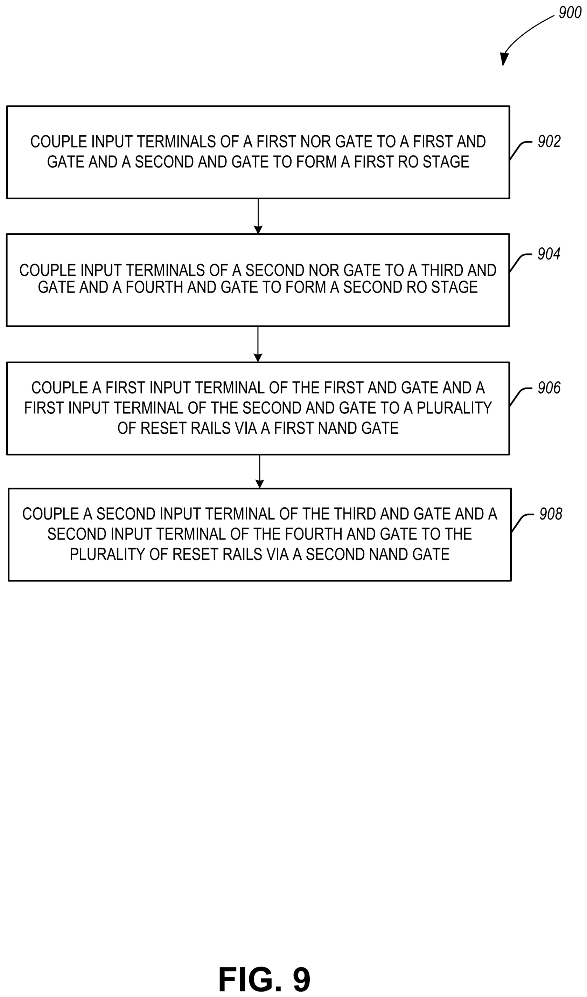

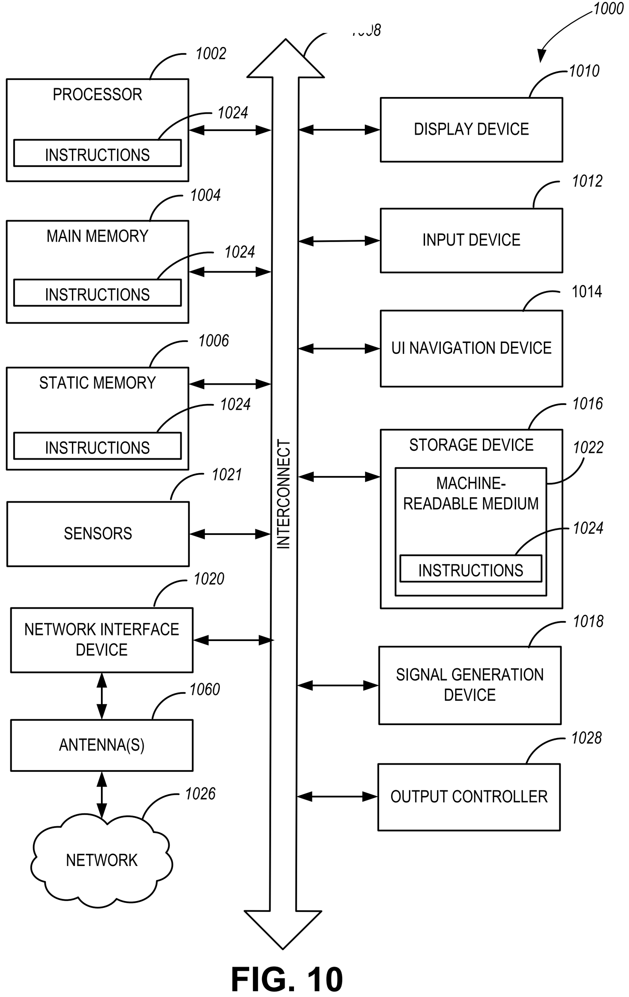

FIG. 9 is a flow diagram of an example process of making a ring oscillator, in accordance with some embodiments. Referring to FIG. 9, process 900 includes operations 902, 904, 906, and 908, which may be executed by a processor, an embedded controller, a receiver circuit, a transceiver circuit, or another processor of a computing device (e.g., hardware processor 1002 of machine 1000 illustrated in FIG. 10, which can include one or more of the circuits discussed in connection with FIGS. 1-8). In some embodiments, one or more of the circuits described in connection with FIGS. 1-8 can perform the functionalities (or include the configurations or circuitry) associated with FIG. 9, as well as one or more of the examples listed below.

At operation 902, input terminals of a first NOR gate (e.g., NOR gate 220) are coupled to a first AND gate (e.g., AND gate 216) and a second AND gate (e.g., AND gate 218) to form a first RO stage (e.g., RO stage 215).

At operation 904, input terminals of a second NOR gate (e.g., NOR gate 214) are coupled to a third AND gate (e.g., AND gate 210) and a fourth AND gate (e.g., AND gate 212) to form a second RO stage (e.g., RO stage 217).

At operation 906, a first input terminal of the first AND gate and a first input terminal of the second AND gate are coupled to a plurality of reset rails (e.g., reset rails 230 and 232) via a first NAND gate (e.g., NAND gate 222).

At operation 908, a second input terminal of the third AND gate and a second input terminal of the fourth AND gate to the plurality of reset rails (e.g., reset rails 230 and 232) via a second NAND gate (e.g., NAND gate 226).

FIG. 10 illustrates a block diagram of an example machine 1000 upon which any one or more of the techniques (e.g., methodologies) discussed herein may perform. In alternative embodiments, the machine 1000 may operate as a standalone device or may be connected (e.g., networked) to other machines. In a networked deployment, machine 1000 may operate in the capacity of a server machine, a client machine, or both in server-client network environments. In an example, machine 1000 may function as a peer machine in a peer-to-peer (P2P) (or other distributed) network environment. The machine 1000 may be a personal computer (PC), a tablet PC, a set-top box (STB), a personal digital assistant (PDA), a portable communications device, a mobile telephone, a smartphone, a web appliance, a network router, switch or bridge, or any other computing device capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations. The terms "machine," "computing device," and "computer system" are used interchangeably.

Machine (e.g., computer system) 1000 may include a hardware processor 1002 (e.g., a central processing unit (CPU), a graphics processing unit (GPU), a hardware processor core, or any combination thereof), a main memory 1004, and a static memory 1006, some or all of which may communicate with each other via an interlink (e.g., bus) 1008. In some aspects, the main memory 1004, the static memory 1006, or any other type of memory (including cache memory) used by machine 1000 can be configured based on the disclosed techniques or can implement the disclosed memory devices.

Specific examples of main memory 1004 include Random Access Memory (RAM) and semiconductor memory devices, which may include, in some embodiments, storage locations in semiconductors such as registers. Specific examples of static memory 1006 include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; RAM; and CD-ROM and DVD-ROM disks.

Machine 1000 may further include a display device 1010, an input device 1012 (e.g., a keyboard), and a user interface (UI) navigation device 1014 (e.g., a mouse). In an example, the display device 1010, the input device 1012, and the UI navigation device 1014 may be a touchscreen display. The machine 1000 may additionally include a storage device (e.g., drive unit or another mass storage device) 1016, a signal generation device 1018 (e.g., a speaker), a network interface device 1020, and one or more sensors 1021, such as a global positioning system (GPS) sensor, compass, accelerometer, or other sensors. The machine 1000 may include an output controller 1028, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.). In some embodiments, the hardware processor 1002 and/or instructions 1024 may comprise processing circuitry and/or transceiver circuitry.

The storage device 1016 may include a machine-readable medium 1022 on which one or more sets of data structures or instructions 1024 (e.g., software) embodying or utilized by any one or more of the techniques or functions described herein can be stored. Instructions 1024 may also reside, completely or at least partially, within the main memory 1004, within static memory 1006, or the hardware processor 1002 during execution thereof by machine 1000. In an example, one or any combination of the hardware processor 1002, the main memory 1004, the static memory 1006, or the storage device 1016 may constitute machine-readable media.

Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

While the machine-readable medium 1022 is illustrated as a single medium, the term "machine-readable medium" may include a single medium or multiple media (e.g., a centralized or distributed database and/or associated caches and servers) configured to store instructions 1024.

An apparatus of machine 1000 may be one or more of a hardware processor 1002 (e.g., a central processing unit (CPU), a graphics processing unit (GPU), a hardware processor core, or any combination thereof), a main memory 1004 and a static memory 1006, one or more sensors 1021, a network interface device 1020, one or more antennas 1060, a display device 1010, an input device 1012, a UI navigation device 1014, a storage device 1016, instructions 1024, a signal generation device 1018, and an output controller 1028. The apparatus may be configured to perform one or more of the methods and/or operations disclosed herein. The apparatus may be intended as a component of machine 1000 to perform one or more of the methods and/or operations disclosed herein and/or to perform a portion of one or more of the methods and/or operations disclosed herein. In some embodiments, the apparatus may include a pin or other means to receive power. In some embodiments, the apparatus may include power conditioning hardware.

The term "machine-readable medium" may include any medium that is capable of storing, encoding, or carrying instructions for execution by machine 1000 and that causes machine 1000 to perform any one or more of the techniques of the present disclosure, or that is capable of storing, encoding, or carrying data structures used by or associated with such instructions. Nonlimiting machine-readable medium examples may include solid-state memories and optical and magnetic media. Specific examples of machine-readable media may include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); and CD-ROM and DVD-ROM disks. In some examples, machine-readable media may include non-transitory machine-readable media. In some examples, machine-readable media may include machine-readable media that is not a transitory propagating signal.

The instructions 1024 may further be transmitted or received over a communications network 1026 using a transmission medium via the network interface device 1020 utilizing any one of several transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 802.11 family of standards known as Wi-Fi®, IEEE 802.16 family of standards known as WiMax®), IEEE 802.8.4 family of standards, a Long Term Evolution (LTE) family of standards, a Universal Mobile Telecommunications System (UMTS) family of standards, peer-to-peer (P2P) networks, among others.

In an example, the network interface device 1020 may include one or more physical jacks (e.g., Ethernet, coaxial, or phone jacks) or one or more antennas to connect to the communications network 1026. In an example, the network interface device 1020 may include one or more antennas 1060 to wirelessly communicate using at least one single-input multiple-output (SIMO), multiple-input multiple-output (MIMO), or multiple-input single-output (MISO) techniques. In some examples, the network interface device 1020 may wirelessly communicate using multiple-user MIMO techniques. The term "transmission medium" shall be taken to include any intangible medium that can store, encode, or carry instructions for execution by machine 1000 and includes digital or analog communications signals or other intangible media to facilitate communication of such software.

Examples, as described herein, may include, or may operate on, logic or several components, modules, or mechanisms. Modules are tangible entities (e.g., hardware) capable of performing specified operations and may be configured or arranged in a particular manner. In an example, circuits may be arranged (e.g., internally or concerning external entities such as other circuits) in a specified manner as a module. In an example, the whole or part of one or more computer systems (e.g., a standalone, client, or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part, all, or any operation described herein. Considering examples in which modules are temporarily configured, each of the modules need not be instantiated at any one moment in time. For example, where the modules comprise a general-purpose hardware processor configured using the software, the general-purpose hardware processor may be configured as respective different modules at separate times. The software may accordingly configure a hardware processor, for example, to constitute a particular module at one instance of time and to constitute a different module at a different instance of time.

Some embodiments may be implemented wholly or partially in software and/or firmware. This software and/or firmware may take the form of instructions contained in or on a non-transitory computer-readable storage medium. Those instructions may then be read and executed by one or more processors to enable the performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read-only memory (ROM), random access memory (RAM), magnetic disk storage media, optical storage media, flash memory, etc.

The above-detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, examples that include the elements shown or described are also contemplated. Moreover, also contemplated are examples using any combination or permutation of those elements shown or described (or one or more aspects thereof), either with respect to a particular example (or one or more aspects thereof) or with respect to other examples (or one or more aspects thereof) shown or described herein.

Publications, patents, and patent documents referred to in this document are incorporated by reference herein in their entirety, as though individually incorporated by reference. In the event of inconsistent usage between this document and those documents so incorporated by reference, the usage in the incorporated reference(s) is supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc., are used merely as labels and are not intended to suggest a numerical order for their objects.

The embodiments as described above may be implemented in various hardware configurations that may include a processor for executing instructions that perform the techniques described. Such instructions may be contained in a machine-readable medium such as a suitable storage medium or a memory or other processor-executable medium.

The embodiments as described herein may be implemented in several environments, such as part of a system on chip, a set of intercommunicating functional blocks, or similar, although the scope of the disclosure is not limited in this respect.

Described implementations of the subject matter can include one or more features, alone or in combination, as illustrated below by way of examples.

Example 1 is an apparatus comprising a first OR gate comprising a first input terminal, a second input terminal, and an output terminal; a second OR gate comprising a first input terminal, a second input terminal, and an output terminal; a first NAND gate comprising a first input terminal coupled to the output terminal of the first OR gate, and a second input terminal coupled to the output terminal of the second OR gate; and a second NAND gate comprising an output terminal coupled to the first input terminal of the second OR gate.

In Example 2, the subject matter of Example 1 includes a first inverter comprising an input terminal coupled to an output terminal of the second NAND gate and an output terminal coupled to the first input terminal of the first OR gate.

In Example 3, the subject matter of Example 2 includes a third OR gate comprising a first input terminal coupled to an output terminal of the first NAND gate.

In Example 4, the subject matter of Example 3 includes a fourth OR gate comprising a first input terminal coupled to the second input terminal of the second OR gate.

In Example 5, the subject matter of Example 4 includes a third NAND gate comprising a first input terminal coupled to an output terminal of the third OR gate and a second input terminal coupled to an output terminal of the fourth OR gate.

In Example 6, the subject matter of Example 5 includes a fourth NAND gate comprising an output terminal coupled to a second input terminal of the third OR gate.

In Example 7, the subject matter of Example 6 includes a second inverter comprising an input terminal coupled to the output terminal of the fourth NAND gate and an output terminal coupled to the second input terminal of the fourth OR gate.

In Example 8, the subject matter of Example 7 includes a first reset rail to supply a first reset signal, the first reset rail coupled to a first input terminal of the second NAND gate, and a first input terminal of the fourth NAND gate.

In Example 9, the subject matter of Example 8 includes a second reset rail to supply a second reset signal, the second reset rail coupled to a second input terminal of the second NAND gate, and a second input terminal of the fourth NAND gate.

In Example 10, the subject matter of Example 9 includes a fifth NAND gate comprising an output terminal coupled to the second input terminal of the first OR gate.

In Example 11, the subject matter of Example 10 includes a fifth OR gate, wherein an output terminal of the third NAND gate is coupled to a first input terminal of the fifth OR gate.

In Example 12, the subject matter of Examples 7-11 includes a system-on-chip (SoC), the SoC comprising an integrated circuit (IC), the IC comprising at least one of the first OR gate, the second OR gate, the third OR gate, the fourth OR gate, the first NAND gate, the second NAND gate, the third NAND gate, or the fourth NAND gate.

In Example 13, the subject matter of Example 12 includes subject matter where the SoC further comprises at least one connector and wherein the at least one connector conforms with at least one of a Universal Serial Bus (USB) specification, a High-Definition Multimedia Interface (HDMI) specification, a Thunderbolt specification, a Peripheral Component Interconnect Express (PCIe) specification, or an Ethernet specification.

Example 14 is an apparatus comprising a first ring oscillator (RO) stage comprising a first AND gate comprising a first input terminal, a second input terminal, and an output terminal; a second AND gate comprising a first input terminal, a second input terminal, and an output terminal; and a first NOR gate comprising a first input terminal coupled to the output terminal of the first AND gate and a second input terminal coupled to the output terminal of the second AND gate; and a second RO stage comprising: a third AND gate comprising a first input terminal, a second input terminal, and an output terminal; a fourth AND gate comprising a first input terminal, a second input terminal, and an output terminal; and a second NOR gate comprising a first input terminal coupled to the output terminal of the third AND gate and a second input terminal coupled to the output terminal of the fourth AND gate.

In Example 15, the subject matter of Example 14 includes subject matter where the first input terminal of the first AND gate and the first input terminal of the second AND gate receive at least one input selection signal and wherein the at least one input selection signal is based on a first reset signal and a second reset signal.

In Example 16, the subject matter of Example 15 includes subject matter where the first NOR gate receives an input signal from the second RO stage or an input signal from a prior RO stage based on the at least one input selection signal.

In Example 17, the subject matter of Examples 14-16 includes subject matter where the second input terminal of the third AND gate and the second input terminal of the fourth AND gate receive at least one input selection signal and wherein the at least one input selection signal is based on a first reset signal and a second reset signal.

In Example 18, the subject matter of Example 17 includes subject matter where the second NOR gate receives an input signal from the first RO stage or an input signal from a prior RO stage based on the at least one input selection signal.

Example 19 is a process of making a ring oscillator (RO), comprising coupling input terminals of a first NOR gate to a first AND gate and a second AND gate to form a first RO stage; coupling input terminals of a second NOR gate to a third AND gate and a fourth AND gate to form a second RO stage; coupling a first input terminal of the first AND gate and a first input terminal of the second AND gate to a plurality of reset rails via a first NAND gate; and coupling a second input terminal of the third AND gate and a second input terminal of the fourth AND gate to the plurality of reset rails via a second NAND gate.

In Example 20, the subject matter of Example 19 includes coupling the first input terminal of the second AND gate to the first NAND gate via a first inverter and coupling the second input terminal of the third AND gate to the second NAND gate via a second inverter.

Example 21 is at least one machine-readable medium including instructions that, when executed by processing circuitry, cause the processing circuitry to perform operations to implement any of Examples 1-20.

Example 22 is an apparatus comprising means to implement any of Examples 1-20.

Example 23 is a system to implement any of Examples 1-20.

Example 24 is a method to implement any of Examples 1-20.

The above description is intended to be illustrative and not restrictive. For example, the above-described examples (or one or more aspects thereof) may be used in combination with others. Other embodiments may be used, such as by one of ordinary skill in the art upon reviewing the above description. The abstract is to allow the reader to ascertain the nature of the technical disclosure quickly. It is submitted with the understanding that it will not be used to interpret or limit the scope or meaning of the claims. Also, in the above Detailed Description, various features may be grouped to streamline the disclosure. However, the claims may not set forth every feature disclosed herein as embodiments may feature a subset of said features. Further, embodiments may include fewer features than those disclosed in a particular example. Thus, the following claims are hereby incorporated into the Detailed Description, with a claim standing on its own as a separate embodiment. The scope of the embodiments disclosed herein is to be determined regarding the appended claims, along with the full scope of equivalents to which such claims are entitled.

**Claims**

1.  An apparatus comprising:

    a first OR gate comprising a first input terminal, a second input terminal, and an output terminal;
    a second OR gate comprising a first input terminal, a second input terminal, and an output terminal;
    a first NAND gate comprising a first input terminal coupled to the output terminal of the first OR gate, and a second input terminal coupled to the output terminal of the second OR gate; and
    a second NAND gate comprising an output terminal coupled to the first input terminal of the second OR gate.

2.  The apparatus of claim 1, further comprising:

    a first inverter comprising an input terminal coupled to an output terminal of the second NAND gate and an output terminal coupled to the first input terminal of the first OR gate;
    a third OR gate comprising a first input terminal coupled to an output terminal of the first NAND gate; and
    a fourth OR gate comprising a first input terminal coupled to the second input terminal of the second OR gate.

3. The apparatus of claim 2, further comprising:

a third NAND gate comprising a first input terminal coupled to an output terminal of the third OR gate and a second input terminal coupled to an output terminal of the fourth OR gate;
a fourth NAND gate comprising an output terminal coupled to a second input terminal of the third OR gate; and
a second inverter comprising an input terminal coupled to the output terminal of the fourth NAND gate and an output terminal coupled to the second input terminal of the fourth OR gate.

4. The apparatus of claim 3, further comprising:

a first reset rail to supply a first reset signal, the first reset rail coupled to a first input terminal of the second NAND gate, and a first input terminal of the fourth NAND gate;
a second reset rail to supply a second reset signal, the second reset rail coupled to a second input terminal of the second NAND gate, and a second input terminal of the fourth NAND gate;
a fifth NAND gate comprising an output terminal coupled to the second input terminal of the first OR gate; and
a fifth OR gate, wherein an output terminal of the third NAND gate is coupled to a first input terminal of the fifth OR gate.

5. The apparatus of any of claims 3 or 4, comprising:
a system-on-chip ,SoC, the SoC comprising an integrated circuit ,IC), the IC comprising at least one of the first OR gate, the second OR gate, the third OR gate, the fourth OR gate, the first NAND gate, the second NAND gate, the third NAND gate, or the fourth NAND gate.

6. The apparatus of claim 5, wherein the SoC further comprises at least one connector, and wherein the at least one connector conforms with at least one of a Universal Serial Bus (USB) specification, a High-Definition Multimedia Interface ,HDMI, specification, a Thunderbolt specification, a Peripheral Component Interconnect Express ,PCIe, specification, or an Ethernet specification.

7. An apparatus comprising:

a first ring oscillator ,RO, stage comprising:

a first AND gate comprising a first input terminal, a second input terminal, and an output terminal;
a second AND gate comprising a first input terminal, a second input terminal, and an output terminal; and
a first NOR gate comprising a first input terminal coupled to the output terminal of the first AND gate and a second input terminal coupled to the output terminal of the second AND gate; and

a second RO stage comprising:

a third AND gate comprising a first input terminal, a second input terminal, and an output terminal;
a fourth AND gate comprising a first input terminal, a second input terminal, and an output terminal; and
a second NOR gate comprising a first input terminal coupled to the output terminal of the third AND gate and a second input terminal coupled to the output terminal of the fourth AND gate.

8. The apparatus of claim 7, wherein:

the first input terminal of the first AND gate and the first input terminal of the second AND gate receive at least one input selection signal, and wherein the at least one input selection signal is based on a first reset signal and a second reset signal; and
the first NOR gate receives an input signal from the second RO stage or an input signal from a prior RO stage based on the at least one input selection signal.

9. The apparatus of claim 7, wherein:
the second input terminal of the third AND gate and the second input terminal of the fourth AND gate receive at least one input selection signal, and wherein the at least one input selection signal is based on a first reset signal and a second reset signal.

10. The apparatus of claim 9, wherein the second NOR gate receives an input signal from the first RO stage or an input signal from a prior RO stage based on the at least one input selection signal.

11. A method of making a ring oscillator ,RO, comprising:

coupling input terminals of a first NOR gate to a first AND gate and a second AND gate to form a first RO stage;
coupling input terminals of a second NOR gate to a third AND gate and a fourth AND gate to form a second RO stage;
coupling a first input terminal of the first AND gate and a first input terminal of the second AND gate to a plurality of reset rails via a first NAND gate; and
coupling a second input terminal of the third AND gate and a second input terminal of the fourth AND gate to the plurality of reset rails via a second NAND gate.

12. The method of claim 11, further comprising:
coupling the first input terminal of the second AND gate to the first NAND gate via a first inverter.

13. The method of claim 12, further comprising:
coupling the second input terminal of the third AND gate to the second NAND gate via a second inverter.

14. Machine-readable storage including machine-readable instructions, when executed, causes a computer/transmitter/receiver to implement a method as claimed in any preceding claim.

15. A computer program comprising instructions which, when the program is executed by a computer, cause the computer to carry out a method as claimed in any preceding claim.

FIG. 1

FIG. 2

EP 4 769 944 A2

**FIG. 3**

FIG. 4

FIG. 5

FIG. 6

EP 4 769 944 A2

700

702 →

704 →

2x          2x

706 →

708 →

710 →          2x          2x

FIG. 7

18

**FIG. 8**

*900*

COUPLE INPUT TERMINALS OF A FIRST NOR GATE TO A FIRST AND GATE AND A SECOND AND GATE TO FORM A FIRST RO STAGE — *902*

COUPLE INPUT TERMINALS OF A SECOND NOR GATE TO A THIRD AND GATE AND A FOURTH AND GATE TO FORM A SECOND RO STAGE — *904*

COUPLE A FIRST INPUT TERMINAL OF THE FIRST AND GATE AND A FIRST INPUT TERMINAL OF THE SECOND AND GATE TO A PLURALITY OF RESET RAILS VIA A FIRST NAND GATE — *906*

COUPLE A SECOND INPUT TERMINAL OF THE THIRD AND GATE AND A SECOND INPUT TERMINAL OF THE FOURTH AND GATE TO THE PLURALITY OF RESET RAILS VIA A SECOND NAND GATE — *908*

# FIG. 9

**FIG. 10**